# EUROPÄISCHE PATENTSCHRIFT

(11) **EP 3 133 411 B1**
(45) Veröffentlichungstag und Bekanntmachung des Hinweises auf die Patenterteilung: **19.12.2018**
(21) Anmeldenummer: 15181417.5
(22) Anmeldetag: 18.08.2015
(51) Int. Cl.: H01M 8/04537, G01R 31/36

(54) **VERFAHREN ZUM ÜBERWACHEN DES BETRIEBSZUSTANDS VON BRENNSTOFFZELLEN**
METHOD FOR MONITORING THE OPERATIONAL CONDITION OF FUEL CELLS
PROCEDE DE SURVEILLANCE DE L'ETAT DE FONCTIONNEMENT DE PILES A COMBUSTIBLE

(43) Veröffentlichungstag der Anmeldung: 22.02.2017
(73) Patentinhaber: AVL List GmbH, 8020 Graz (AT)
(72) Erfinder: Eichberger, Bernd, 8010 Graz (AT); Hacker, Viktor, 8042 Graz (AT); Weinberger, Stephan, 8047 Graz (AT); Klambauer, Reinhard, 8063 Hart-Purgstall (AT)
(74) Vertreter: Wietzke, Andreas

(56) Entgegenhaltungen:
- US-A1- 2003 206 021
- US-A1- 2012 135 327
- US-A1- 2014 159 738

## Beschreibung

Die Erfindung entsprechend Anspruch 1 bezieht sich auf ein Verfahren zum Überwachen des Betriebszustandes von Brennstoffzellen, bei welchem einer aus zumindest einer Brennstoffzelle bestehenden Brennstoffzellenanordnung ein Signal im Niederfrequenzbereich zugeführt wird und die auftretende Signalantwort gemessen und ausgewertet wird, wobei das zugeführte Signal zwei Einzelsignale unterschiedlicher Frequenzen umfasst, die Signalantwort bei ausgewählten Frequenzen der Intermodulationsprodukte der zugeführten Einzelsignale gemessen wird und die gemessenen Intermodulationssignale zur Beurteilung des Betriebszustandes herangezogen werden und die Signalantwort bei Frequenzen der Intermodulationsprodukte 2. Ordnung gemessen wird, wobei das zugeführte Signal genau zwei Einzelsignale umfasst.

Ebenso bezieht sich die Erfindung entsprechend Anspruch 3 auf eine Messanordnung zum Überwachen des Betriebszustandes einer aus zumindest einer Brennstoffzelle bestehenden Brennstoffzellenanordnung, bei welcher an die Brennstoffzellenanordnung eine Betriebslast geschaltet ist, weiters zumindest ein Einspeiseverstärker zum Einspeisen von zumindest einem niederfrequenten Signal vorgesehen ist, dessen Ausgang an die Brennstoffzellenanordnung angekoppelt ist und mit einer gleichfalls an die Brennstoffzellenanordnung angekoppelten Auswerteeinrichtung zum Erfassen einer Signalantwort auf das zumindest eine eingespeiste Signal, wobei die Messanordnung dazu eingerichtet ist, der Brennstoffzellenanordnung genau zwei Einzelsignale im Niederfrequenzbereich unterschiedlicher Frequenzen zuzuführen und die Auswerteeinrichtung dazu eingerichtet ist, die Signalantwort bei ausgewählten Frequenzen der Intermodulationsprodukte der zugeführten Einzelsignale zu erfassen, und die gemessenen Intermodulationssignale zur Beurteilung des Betriebszustandes herangezogen werden, und hinsichtlich zumindest ihrer Amplitude zu messen, um zumindest ein Ausgangssignal zu erhalten, und die Signalantwort bei Frequenzen der Intermodulationsprodukte 2. Ordnung zu messen. Verfahren der gegenständlichen Art sind bekannt. So geht aus der EP 1 646 101 B1 der Anmelderin ein Verfahren zum Bestimmen kritischer Betriebszustände von Brennstoffzellen als bekannt hervor, welches von dem Umstand Gebrauch macht, dass bei Einspeisen eines Wechselstromsignals in eine Brennstoffzelle bzw. einen Brennstoffzellenstapel der Oberwellenanteil der sich ergebenden Signalantwort Rückschlüsse auf den Betriebszustand der Brennstoffzelle zulässt. Bei der bevorzugten Einspeisung eines Stroms wird als Signalantwort eine Spannung gemessen, deren Oberwellenanteile gemessen und qualitativ/quantitativ ausgewertet werden. Nähere Berechnungsverfahren zum Auswerten der sich ergebenden Signalantwort, insbesondere auf Basis einer Klirrfaktormessung, gehen aus der WO 2013/164415 A1 der Anmelderin hervor.

Ein weiteres Verfahren der gegenständlichen Art ist in der US 8,906,568 B2 beschrieben, wobei dieses Verfahren zwei Signale sehr niedriger Frequenzen, beispielsweise 1 Hz und 3 Hz, verwendet und ebenfalls auftretende Schwingungen höherer Ordnung überwacht.

Ausgangspunkt der bekannten Messverfahren bzw. Vorrichtungen ist der Umstand, dass die Strom/Spannungskennlinie einer Brennstoffzelle Bereiche mit starker Nichtlinearität ebenso aufweist, wie Bereiche, in welchen die Kennlinie weitgehend linear verläuft. Bei Einspeisen eines sinusförmigen Stroms in die Brennstoffzelle bzw. einen Stapel wird sich eine weitgehend sinusförmige Signalantwort mit einem geringen Oberwellenanteil und dementsprechend einem kleinen Klirrfaktor ergeben, sofern die Brennstoffzelle in einem linearen Bereich ihrer Kennlinie arbeitet. Arbeitet jedoch die Brennstoffzelle in einem nicht ordnungsgemäßen Betriebszustand, beispielsweise in einem unterstöchiometrischen Betrieb, gelangt man in einen stark nichtlinearen Bereich der Strom/Spannungskennlinie und der Oberwellenanteil der als Signalantwort gemessenen Spannung steigt stark an.

Im Rahmen der vorliegenden Beschreibung ist unter einem niederfrequenten Signal ein solches zu verstehen, dessen Frequenz bzw. Frequenzanteile im Allgemeinen nicht oberhalb einer Frequenz von 10 bis 20 kHz liegen. Der in dieser Beschreibung der einfachen Schreibweise wegen verwendete Begriff "Wechselstromsignal" soll in gleicher Weise Wechselströme und Wechselspannungen umfassen.

Wenngleich es das bekannte, auf der Messung der Oberwellenanteile beruhende Verfahren gestattet, viele Aussagen über den Betriebszustand der Brennstoffzelle zu treffen, setzt es andererseits einen hohen Aufwand für die Auswertung voraus. Dies liegt zum Teil darin, dass man eine größere Anzahl von Oberschwingungen, somit gezielt eine relativ hohe Anzahl von Frequenzen, z.B. bis zur 9.-ten oder 11.-ten Oberschwingung, erfassen möchte und dass andererseits das Einkoppeln eines sinusförmigen Stroms ausreichender Größe in einen Brennstoffzellenstapel, an dem eine Spannung in der Größenordnung von 500 Volt liegen kann, technische Probleme bereitet, insbesondere wenn die Frequenzen des einzuspeisenden Signals, sei es eine Spannung oder ein Strom, relativ niedrig sind, z.B. wie oben zum Stand der Technik erwähnt unterhalb von 10 Hz liegen. Auch muss, da die Oberwellenanteile ein entscheidender Faktor sind, der Klirrfaktor des einzuspeisenden Signals oder Signale sehr gering sein, was gleichfalls einen hohen Aufwand bedeutet.

Eine Aufgabe der Erfindung liegt darin, ein Verfahren bzw. eine Vorrichtung zu schaffen, welches es ermöglicht, auf verhältnismäßig einfache und kostengünstige Weise rasch kritische Betriebszustände detektieren zu können.

Diese Aufgabe wird mit einem Verfahren der eingangs genannten Art gelöst, bei welchem erfindungsgemäß entsprechend Anspruch 1 die Signalantwort bei der Frequenz f₂ - f₁ des niederfrequenten realen Intermodulationsproduktes 2. Ordnung mit Hilfe eines Bandpassfilters gefiltert und gemessen wird.

Ein wesentlicher Vorteil der Erfindung liegt darin, dass im Gegensatz zu einer Oberwellenanalyse keine hohe Bandbreite bei der Messung der Signalantwort erforderlich ist und man sich auf eine sehr reduzierte Anzahl an Intermodulationsfrequenzen beschränken kann. Man kann Signale mit hohen Frequenzen einprägen und bei niedrigen Frequenzen messen, die auch genau bekannt sind, sodass analoge oder digitale Bandpassfilter eingesetzt werden und nicht eine FFT (schnelle Fourier-Transformation) angewendet werden muss. Auch kann die Messung in Echtzeit erfolgen.

Außerdem ist die Erfindung in vielen Fällen der Praxis ausreichend und kostengünstig, sowie rasch durchführbar.

Zur genaueren Bestimmung des Ausmaßes bzw. der Erstreckung von Nichtlinearitäten ist es besonders zweckmäßig, wenn aufeinanderfolgende Messungen mit unterschiedlichen Amplituden der zugeführten Einzelsignale durchgeführt werden und durch Auswertung der gemessenen Intermodulationssignale das Ausmaß der Nichtlinearität der Strom/Spannungskennlinie der Brennstoffzellenanordnung bestimmt wird.

Die gestellte Aufgabe wird auch mit einer Messanordnung der oben genannten Art gelöst, bei welcher erfindungsgemäß entsprechend Anspruch 3 die Messanordnung ferner dazu eingerichtet ist, die Signalantwort bei der Frequenz f₂ - f₁ des niederfrequenten realen Intermodulationsproduktes 2. Ordnung mit Hilfe eines Bandpassfilters zu filtern und zu messen, wodurch ein kostengünstiger Aufbau möglich ist und wobei auch analoge Filter verwendet werden können.

In manchen Fällen ist es einfacher und auch kostengünstiger, wenn für jedes einzuspeisende Einzelsignal ein Leistungsverstärker vorgesehen ist.

In Hinblick auf die oft hohen Spannungen der Brennstoffzellenanordnung ist es besonders zweckmäßig, wenn der Ausgang des zumindest einen Leistungsverstärkers über einen Koppelkondensator mit der Brennstoffzellenanordnung verbunden ist.

Die Erfindung samt weiteren Vorteilen ist im Folgenden an Hand beispielsweiser Ausführungsbeispiele näher erläutert, die in der Zeichnung veranschaulicht sind. In dieser zeigen
Fig. 1 ein vereinfachtes Blockschaltbild einer beispielsweisen Messanordnung, die zwar nicht unter die Erfindung fällt, jedoch nützlich zu deren Verständnis ist und zur Durchführung eines Verfahrens geeignet ist,
Fig.1a ein vereinfachtes Blockschaltbild einer beispielsweisen erfindungsgemäßen Messanordnung, welche zur Durchführung des erfindungsgemäßen Verfahrens geeignet ist,
Fig. 2 in einem Diagramm den Spannungs-/Stromverlauf einer typischen Brennstoffzelle und schematisch und symbolisch die Einspeisung eines niederfrequenten Signals in die Zelle mit möglichen Signalantworten und
Fig. 3 bis 6 in Amplituden-/ Frequenzdiagrammen Basisfrequenzen von in eine Brennstoffzelle eingespeisten Signalen und das sich ergebende Antwortspektrum für verschiedene Frequenzkombinationen.

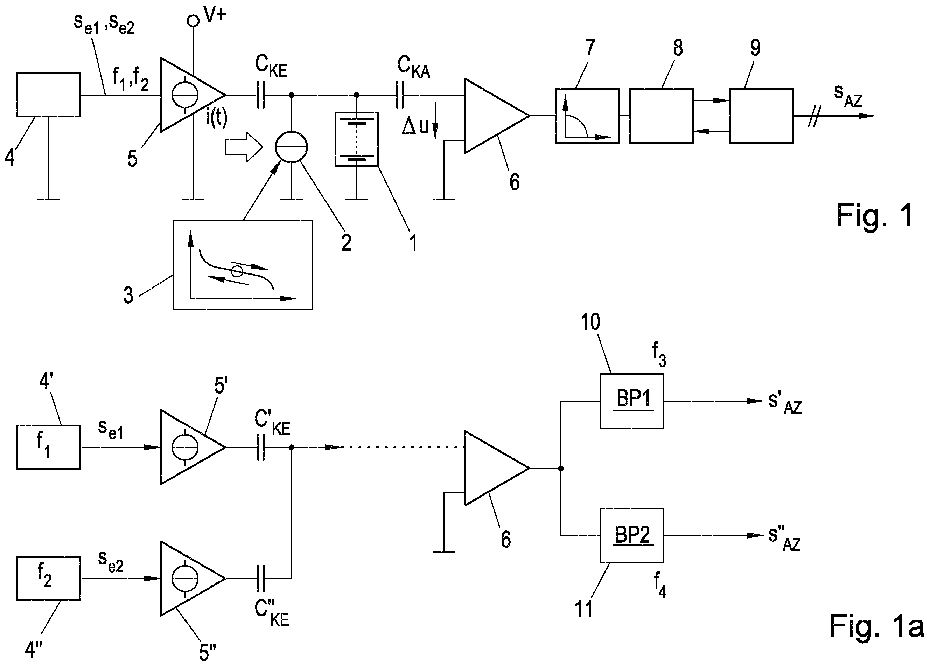

**Fig. 1** zeigt den prinzipiellen Aufbau einer Messanordnung zum Überwachen des Betriebszustandes einer Brennstoffzellenanordnung **1**, welche während der Messung an einer Last **2**, vorzugsweise einer handelsüblichen elektronischen Stromsenke liegt und einen einstellbaren Strom I liefert, wodurch der Arbeitspunkt der Zellen beliebig verschoben werden kann, was in einem symbolischen Kästchen **3** angedeutet ist. Zur Vereinfachung wird im Rahmen dieser Beschreibung oft nur von einer Brennstoffzelle oder einer Brennstoffzellenanordnung gesprochen, doch soll dieser Begriff ebenso einen Brennstoffzellenstapel umfassen, d.h. die Serienschaltung einer größeren Anzahl von Brennstoffzellen. Solche Brennstoffzellenstapel, die beispielsweise zur Energieversorgung in Kraftfahrzeugen eingesetzt werden, können aus mehreren hundert Einzelzellen bestehen und dementsprechend hohe Betriebsspannungen von einigen hundert Volt aufweisen.

In einem Signalgenerator **4** können mehrere Signale unterschiedlicher Frequenzen erzeugt werden, im vorliegenden Fall zwei Einzelsignale sₑ₁(t), sₑ₂(t) mit Frequenzen f₁, f₂, wobei diese Frequenzen im Folgenden meistens mit fₑ₁, fₑ₂ bezeichnet werden, da es sich um Frequenzen eingespeister Signale handelt. Die Frequenzen der Signale können ebenso verändert werden, wie deren Amplituden. Es sollte klar sein, dass der Begriff "Signalgenerator" einen Generator zum Erzeugen mehrerer Signale ebenso umfasst, wie mehrere Signalgeneratoren, die je ein Signal erzeugen. Dem Signalgenerator 4 ist ein Leistungsverstärker **5** nachgeordnet, welchem die Einzelsignale sₑ₁(t), sₑ₂(t) zugeführt werden und dessen Ausgang über einen Einkoppelkondensator C_{KE} mit der Brennstoffzellenanordnung 1 verbunden ist. Der Koppelkondensator C_{KE} ist nicht auf jeden Fall erforderlich, jedoch in vielen Fällen in Hinblick auf die relativ hohe Betriebsspannung von Brennstoffzellen zweckmäßig. Im vorliegenden Fall speist der Leistungsverstärker 5 einen Strom i(t) in die Brennstoffzelle 1 ein. Über einen Auskoppelkondensator C_{KA} wird das an den Klemmen der Brennstoffzellenanordnung 1 durch den eingespeisten Strom an der Kennlinie entstehende Antwortsignal - eine Spannung u(t) dem Eingang eines Verstärkers **6** zugeführt.

An dieser Stelle sei darauf hingewiesen, dass der Brennstoffzellenanordnung 1 auch eine Spannung eingeprägt werden kann, wenngleich das Einspeisen eines Stroms die bevorzugte Variante ist. Falls eine Spannung eingeprägt wird, wird als Signalantwort der niederfrequente Strom ausgewertet, welcher bei Einprägen der niederfrequenten Spannung auftritt. Es ist dem Fachmann klar, dass in diesem Fall eine dem Strom proportionale Spannung dem Eingang eines Verstärkers, entsprechend dem Verstärker 6, zugeführt wird.

Das Ausgangssignal des Verstärkers 6, der hier ein Differenzverstärker ist, wird nun weiter verarbeitet, um Amplitude und gegebenenfalls Phase der in der Signalantwort enthaltenen Intermodulationsprodukte zu bestimmen. Im vorliegenden Fall der Fig. 1 erfolgt zu diesem Zweck eine digitale Signalverarbeitung. Das Ausgangssignal des Verstärkers 6 wird zunächst in einem Tiefpass 7 von hohen Frequenzanteilen befreit, um den Alias-Effekt bei der Signalabtastung zu verringern. Auf den Tiefpass 7 folgt ein A/D-Konverter **8**, dessen Ausgangssignal einem Mikroprozessor **9** zugeführt wird, in welchem eine FFT (schnelle Fourier-Transformation) durchgeführt wird, um ein Ausgangssignal S_{AZ} zu erhalten, welches Information bezüglich der Amplitudenwerte und gegebenenfalls auch der Phasenlage der Intermodulationsprodukte in der Signalantwort enthält.

Im gezeigten Beispiel erfolgt die Signalverarbeitung weitgehend digital, doch ist es ebenso möglich, analoge Bandpassfilter zur Bestimmung der Intermodulationsprodukte heranzuziehen. Hierzu sei auch auf **Fig. 1a** verwiesen, welche eine Variante der Messanordnung nach Fig. 1 zeigt. Das Einspeisen von zwei Einzelsignalen sₑ₁(t), sₑ₂(t) erfolgt hier, ausgehend von zwei Signalgenerator **4'**, **4"** über zwei getrennte Leistungsverstärker **5'**, **5"** und zwei Koppelkondensatoren **C'_{KE}**, **C"_{KE}.** Am Ausgang der Messanordnung sind andererseits dem Verstärker 6 zwei oder mehr, im vorliegenden Fall zwei Bandpassfilter **10**, **11** nachgeordnet, welche schmalbandig die gewünschten Signale der Signalantwort sₐᵢ(t) bei ausgewählten Frequenzen f₃, f₄ herausfiltern, um ein Ausgangssignal, bestehend aus zwei (oder mehr) Einzelsignalen s'_{AZ}, s"_{AZ} dieser Frequenzen f₃, f₄ zu liefern.

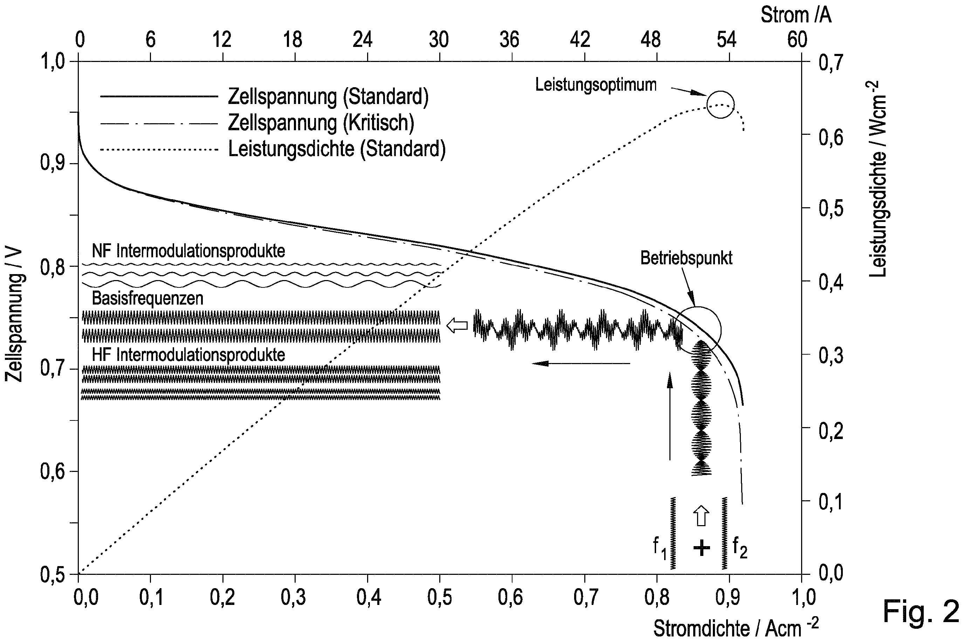

Nachstehend wird an Hand der **Fig. 2** die Entstehung der Signalantwort in einer Brennstoffzelle erläutert. Gezeigt ist beispielhaft die Strom-Spannungs-Kennlinie eines Brennstoffzellenstapels unter optimalen Betriebsbedingungen (durchgezogen), sowie unter kritischen Betriebsbedingungen (strichpunktiert) dargestellt. Der Betriebspunkt (Arbeitspunkt) wird in der Praxis meist nahe am Leistungsmaximum gewählt. Das erfindungsgemäße Verfahren zur Erkennung kritischer Betriebszustände basiert darauf, das Maß der Nichtlinearität zu überwachen. Bei Einspeisung genau zweier sinusförmiger Stromsignale unterschiedlicher Frequenz fₑ₁, fₑ₂, in der Zeichnung mit f₁ und f₂ bezeichnet, treten bei nicht linearem Übertragungsverhalten im Spannungs-Antwortsignal nicht nur Frequenzanteile der eingespeisten Frequenzen, sondern auch niederfrequente und höherfrequente Intermodulationsprodukte auf.

Wird, wie im illustrierten Fall durch die Senkung der Grenzstromdichte, etwa durch Zellflutung, das Ausmaß der Nichtlinearität am Betriebspunkt erhöht, erhöht sich auch der Anteil an Intermodulationsprodukten im Antwortsignal.

Die Wahl des Betriebspunktes ist vor allem durch den Einsatzzweck des Brennstoffzellenstapels bestimmt. Für mobile und transportable Anwendungen mit hohen Anforderungen an die spezifische Leistung, als auch an die Leistungsdichte, wird der Betriebspunkt nahe am Leistungsmaximum gewählt. Bei stationären Anlagen wird der Arbeitspunkt im Sinne erhöhter Brennstoffausnutzung bei geringeren Stromdichten gewählt. In beiden Fällen befindet sich der Betriebspunkt in oder nahe einem nichtlinearen Bereich der Strom-Spannungs-Kennlinie.

Der Betriebspunkt (Strom- bzw. Stromdichte) kann in einem linearen oder bereits in einem nichtlinearen Bereich liegen. Wird ein kritischer Betriebszustand erreicht, so ändert sich die Kennlinie in verschiedener Hinsicht:
(1) Der resultierende Gleichanteil der Zellspannung sinkt geringfügig.
(2) die lokale Steigung der Kennlinie sinkt und
(3) der nicht lineare Anteil der Kennlinie wird je nach Art des kritischen Zustandes und des Betriebspunktes verändert. In der Regel wird der nicht lineare Anteil jedoch ausgeprägter, in besonderen Betriebszuständen, wie im Bereich geringer Stromdichten, nimmt hingegen der nicht lineare Anteil durch erhöhte Aktivierungsverluste ab.

Durch die Abnahme des Gleichanteils kann zwar ein kritischer Zustand erkannt werden, nicht jedoch unterschieden werden, um welchen kritischen Zustand es sich handelt bzw. welche Gegenmaßnahmen getroffen werden müssen. Durch die Analyse des Übertragungsverhaltens bzw. der Signalantwort um den Betriebspunkt in Hinblick auf Steigung und Linearität kann auf die Art des kritischen Zustandes rückgeschlossen werden.

Im dargestellten Betriebspunkt sind verschiedene kritische Zustände möglich:

### Flutung:

In diesem Fall nimmt der nicht lineare Charakter bei sinkendem Gleichanteil zu. Die Zunahme des nicht linearen Charakters entspricht einer Verringerung der Grenzstromdichte (maximal erreichbarer Strom, welcher durch molekulare Diffusion begrenzt wird) bzw. einem Zustand der Zellflutung. Die verstärkte Versorgung der Kathode, die üblicherweise mit Umgebungsluft betrieben wird, zur Abfuhr überschüssigen flüssigen Wassers wäre die korrekte Gegenmaßnahme.

### Austrocknung:

In diesem Fall nimmt der nicht lineare Charakter bei sinkendem Gleichanteil ab. Die Abnahme des nichtlinearen Charakters entspricht der Erhöhung der Grenzstromdichte (maximal erreichbarer Strom) bzw. einem Zustand der Zellaustrocknung, wobei die Abnahme des Gleichanteils aufgrund des gesteigerten Elektrolytwiderstandes zu erklären ist. Die verstärkte Versorgung der Zelle mit Wasser durch geeignete Mittel wäre hier die korrekte Gegenmaßnahme.

Zur Detektion des nicht linearen Verhaltens gibt es mindestens drei Möglichkeiten:
(a) Aufnahme der stationären Strom-Spannungs-Kennlinie: Dies ist jedoch im Betrieb nicht möglich.
(b) Detektion harmonischer Verzerrungen und gesamter harmonischer Verzerrungen: Beim Auftreten einer nicht linearen Übertragungsfunktion entsteht aus einem eingespeisten sinusförmigen Signal ein nicht sinusförmiges Ausgangssignal. Das Ausgangssignal ist "harmonisch" verzerrt (man spricht auch von einem "Klirrfaktor") und setzt sich aus mehreren Sinusfunktionen bei positiven ganzzahligen vielfachen Frequenzen der eingespeisten Signalfrequenz zusammen. Die eingespeisten Signalfrequenzen liegen üblicherweise im Bereich einiger Hz bis kHz. Die Ausgangsfrequenzen liegen bei ganzzahligen Vielfachen der eingespeisten Frequenzen.
(c) Detektion von Intermodulationsprodukten:
   Bei diesem erfindungsgemäß angewendeten Verfahren besteht das eingespeiste Signal aus genau zwei sinusförmigen Signalen im Niederfrequenzbereich mit unterschiedlichen Frequenzen. Im Falle einer nicht linearen Übertragungsfunktion treten im Antwortsignal Mischprodukte der eingespeisten Frequenzen auf. Bei zwei eingespeisten Frequenzen f1, f2 sind die Mischprodukte zweiter Ordnung zwei sinusförmige Signale mit der Frequenz f1+f2 (Summe) und f1-f2 (Differenz). Da sich diese neu entstandenen Signale wiederum untereinander und mit den Eingangssignalen mischen, entstehen weitere Mischprodukte höherer Ordnung. Deren Auswirkung ist wegen des gegenüber den Mischprodukten zweiter Ordnung deutlich niedrigeren Pegels in praktischen Anwendungen meist vernachlässigbar.

Die eingespeisten Signalfrequenzen liegen im Bereich einiger Hz bis kHz, vorzugsweise jedoch im Bereich zwischen 0.1 kHz und 10 kHz. Die Ausgangsfrequenzen liegen entsprechend der Differenzen der eingespeisten Signale im niederfrequenten Bereich, bei den eingespeisten Frequenzen sowie für die Summen im Bereich höherer Frequenzen. Zur Auswertung kann nach einer FFT das gesamte Spektrum herangezogen werden, was nicht unter die Erfindung fällt, oder es können erfindungsgemäß mit Hilfe von analogen oder digitalen Bandpassfiltern gezielt bestimmte Frequenzen der Intermodulationsprodukte gefiltert werden.

Das kapazitive Verhalten der elektrochemischen Doppelschichten an der Brennstoffzellenanode sowie an der Brennstoffzellenkathode führt zu einem Tiefpasscharakter der entsprechenden Nicht-Linearitäten von Anode und Kathode, was die Detektion tiefer Frequenzen < 1 Hz im Intermodulations-Spektrum besonders sinnvoll erscheinen lässt. Insbesondere in Hinblick auf sehr geringe Intermodulationsfrequenzen zeigt die Messung der Intermodulationsprodukte gegenüber der Messung harmonischer Verzerrungen Vorteile bei dem dafür notwendigen messtechnischen Aufbau.

Zum Überwachen des Betriebszustandes von Brennstoffzellen wird in der Praxis in der Regel eine Zellspannungsüberwachung eingesetzt. Im Laborbereich wird zu diesem Zweck eine elektrochemische Impedanzspektroskopie eingesetzt. Dabei werden sinusförmige Signale im Bereich zwischen 0.05 Hz und 10 kHz verwendet. Die Amplituden werden dazu einerseits so hoch wie möglich gewählt, um das Signal/Rausch-Verhältnis zu steigern und andererseits so niedrig, um in dem für Impedanzspektroskopie notwendigen linearen Bereich zu bleiben. Typische Amplituden sind 1 mA cm⁻² bis 10 mA cm⁻². Bei typischen Zellquerschnittsflächen von 50 cm² bis 200 cm² sind damit die Stromamplituden im Bereich von 50 mA bis 2 A.

Um Nicht-Linearitäten zu detektieren sind jedoch höhere Amplituden von Vorteil, doch sind die Amplituden durch die Größe der Koppelkondensatoren beschränkt. Durch die entstehende Hochpasscharakteristik dieser Kondensatoren ist man vor allem die auf Frequenzen >1Hz beschränkt. Der für die Analyse interessante Bereich < 1Hz (Tiefpasscharakteristik der Brennstoffzelle) bleibt ohne die Auswertung von niederfrequenten Intermodulationen maskiert.

Auch diese Problematik hat zu der Erfindung geführt, welche sich auf Intermodulationsprodukte stützt.

Die Anmelderin hat Simulationen und Messungen unter Benutzung des Diagramms nach Fig. 2 durchgeführt, deren Ergebnisse in der nachstehenden Tabelle dargestellt sind. Dabei führt eine Erhöhung der Signalamplituden bei 6000 Hz und 6025 Hz von jeweils 10 mA cm⁻² auf 25 mA cm⁻² zu einem deutlichen Anstieg der Fourier-Komponenten der beispielhaft dargestellten f₂ - f₁ Intermodulation, sowie der 2 f₂ - f₁ Intermodulation. Dies lässt sich durch den nicht linearen Charakter der Kennlinie im Bereich Betriebspunkt ± ∑ Signalamplituden erklären. Wird nur ein kleiner Bereich bei kleine Amplituden analysiert, ist das Verhalten zunehmend linear und die Intermodulationsprodukte verschwinden. Dieser Effekt ermöglicht die gezielte Optimierung der Eingangsamplituden in Hinblick auf die Amplituden der ausgewerteten Intermodulationsfrequenzen sowie der Aussteuerung der Leistungsverstärker für die Signaleinspeisung.

**Tabelle: Auswirkung der Eingangsamplituden auf das Antwortsignal.**

| | | Amplituden des Eingangssignals | | | |
|---|---|---|---|---|---|
| | f / Hz | i / A cm⁻² | | | |
| f₁ | 6000 | 0.025 | 0.02 | 0.01 | Eingangssignal |
| f₂ | 6025 | 0.025 | 0.02 | 0.01 | |
| | | | | | |

| | | Ausgewählte Fourier Komponenten des Ausgangssignals | | | |
|---|---|---|---|---|---|
| | f / Hz | - | - | - | |
| f₂ - f₁ | 25 | 1.26E-06 | 9.06E-07 | 7.44E-08 | Ausgangssignal |
| 2f₂ - f₁ | 50 | 1.21E-07 | 1.85E-07 | 2.26E-07 | |

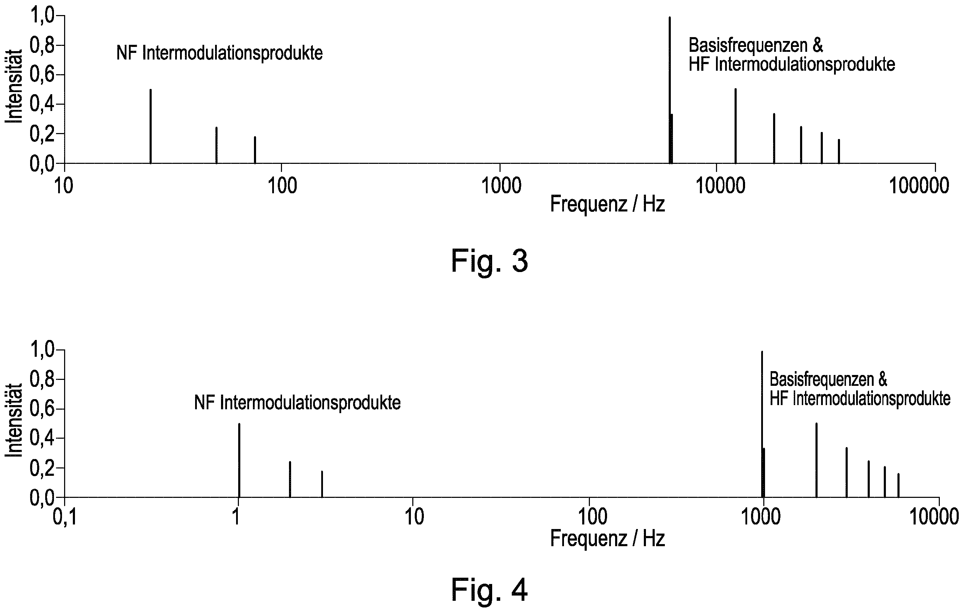

In den **Fig. 3 bis 6** sind schematische Spektren dargestellt. Im Sinne des besseren Überblicks durch die vielfältigen Wechselwirkungen sind diese auf nur je zwei eingespeiste Frequenzen beschränkt. Die dargestellten Spektren stellen sämtliche Intermodulationsprodukte bis zur 6. Ordnung dar. Es ist festzuhalten, dass Intermodulationsprodukte 2. Ordnung, darunter das niederfrequente reale Intermodulationsprodukte 2.Ordnung (f₂-f₁) für die weitere Signalauswertung verfolgt werden. Diese ist in den Abbildungen die kleinste Frequenz.

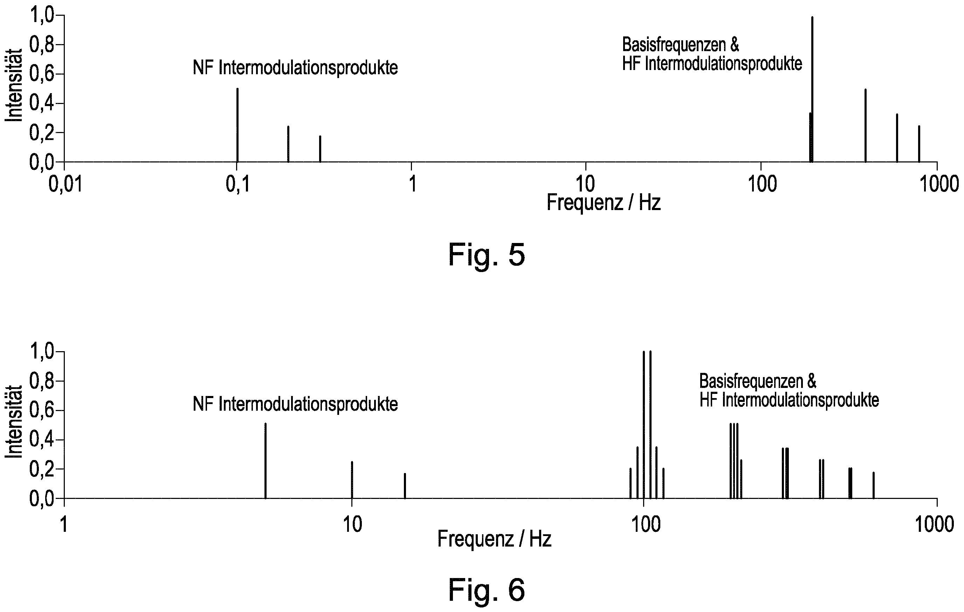

**Fig. 3** zeigt das schematische Ausgangsspektrum und das Antwortspektrum bei Basisfrequenzen f₁ = 6000 Hz und f₂ = 6025 Hz sowie Intermodulationsprodukte bis zur 6. Ordnung, **Fig. 4** ein entsprechendes Spektrum bei Basisfrequenzen f₁ = 1000 Hz f₂ = 1001 Hz, **Fig. 5** ein sinngemäßes Spektrum bei Basisfrequenzen f₁ = 200 Hz f₂ = 200.1 Hz und **Fig. 6** gleiches bei Basisfrequenzen f₁ = 100 Hz f₂ = 105 Hz.

Aus den Spektren erkennt man, dass zur Auswertung niederfrequente Intermodulationsprodukte zur Verfügung stehen, wobei die niedrigste Frequenz (f₂-f₁) der Intermodulationsprodukte für eine praktische Auswertung in Frage kommt. Die Überwachung dieser Frequenz, gegebenenfalls auch weiterer Frequenzen, und deren Auswertung ermöglicht es, die Lage des Betriebspunkt der Brennstoffzellen und damit den jeweiligen Betriebszustand zu erkennen und dementsprechend geeignete Gegenmaßnahmen zu treffen bzw. anzuzeigen, dass ein möglicherweise unerwünschter Betriebszustand vorliegt.

Zur genaueren Bestimmung des Ausmaßes bzw. der Erstreckung von Nichtlinearitäten ist es besonders zweckmäßig, wenn aufeinanderfolgende Messungen mit unterschiedlichen Amplituden der zugeführten Einzelsignale s₁(t), s₂(t) durchgeführt werden und durch Auswertung der gemessenen Intermodulationssignale si1, si2 das Ausmaß der Nichtlinearität der Strom/Spannungskennlinie der Brennstoffzellenanordnung bestimmt wird.

Für die Auswertung auftretender Intermodulationsprodukte werden in erster Linie die Beträge der Antwortsignale herangezogen, da diese Auswertung mit geringem Aufwand rasch erfolgen kann und die erhaltenen Informationen für die Praxis ausreichend sind. Es soll jedoch nicht unerwähnt bleiben, dass auch die Phasenlage der Antwortsignale bei entsprechend bereitgestelltem Referenzsignal Information enthält, die zusätzlich verwendet werden kann, um das Messverfahren zu optimieren. Wählt man beispielsweise jene Antwortsignalfrequenzen der Intermodulationsprodukte, die keine oder nur eine minimale Phasenverschiebung in Bezug auf ein entsprechend bereitgestelltes Referenzsignal zeigen, zur weiteren Verarbeitung, so kann sich eine leichtere Trennung der nichtlinearen Anteile einzelner Verlustmechanismen ergeben.

Da - im Gegensatz zum Stand der Technik - Ausgangspunkt der Messung nicht Verzerrungen höherer Ordnung sind, sondern Differenzfrequenzen, nämlich die entsprechenden Intermodulationsprodukte, muss auf den Frequenzgang und auf andere Verzerrungen der Leistungsverstärker oder Signalquellen kein besonderes Augenmerk gelegt werden, wodurch der Einsatz kostengünstiger, handelsüblicher Produkte möglich ist. Nach dem Stand der Technik kann nämlich bereits ein geringer Klirrfaktor des zugeführten Einspeisesignals die Messung verfälschen oder gar in Frage stellen.

Die Erfindung bietet auch den Vorteil, dass die Verwendung von Koppelkondensatoren nicht so problematisch ist, wie nach dem Stand der Technik, da bei der Erfindung Signale mit vergleichsweise höheren Frequenzen eingespeist werden können, sodass die Werte der Koppelkondensatoren kleiner ausfallen können und die Probleme mit in den Kondensatoren gespeicherten Ladungsmengen reduziert werden.

## Patentansprüche

1. Verfahren zum Überwachen des Betriebszustandes von Brennstoffzellen, bei welchem einer aus zumindest einer Brennstoffzelle bestehenden Brennstoffzellenanordnung (1) ein Signal (sₑ₁(t), sₑ₂(t)) im Niederfrequenzbereich zugeführt wird und die auftretende Signalantwort (sₐᵢ(t)) gemessen und ausgewertet wird, wobei das zugeführte Signal genau zwei Einzelsignale (sₑ₁(t), sₑ₂(t)) unterschiedlicher Frequenzen f₁, f₂ umfasst, die Signalantwort (sₐᵢ(t)) bei ausgewählten Frequenzen f₃, f₄ der Intermodulationsprodukte mf₁ +/- nf₂ der zugeführten Einzelsignale gemessen wird und die gemessenen Intermodulationssignale (sᵢ₁, sᵢ₂) zur Beurteilung des Betriebszustandes herangezogen werden, und die Signalantwort (sₐᵢ(t)) bei Frequenzen der Intermodulationsprodukte 2. Ordnung gemessen wird, wobei die Signalantwort (sₐᵢ(t)) bei der Frequenz f₂ - f₁ des niederfrequenten realen Intermodulationsproduktes 2. Ordnung mit Hilfe eines Bandpassfilters (10,11) gefiltert und gemessen wird.

2. Verfahren nach Anspruch 1, **dadurch gekennzeichnet, dass** aufeinanderfolgende Messungen mit unterschiedlichen Amplituden der zugeführten Einzelsignale (sₑ₁(t), sₑ₂(t)) durchgeführt werden und durch Auswertung der gemessenen Intermodulationssignale (sᵢ₁, sᵢ₂) das Ausmaß der Nichtlinearität der Strom-Spannungskennlinie der Brennstoffzellenanordnung bestimmt wird.

3. Messanordnung zum Überwachen des Betriebszustandes einer aus zumindest einer Brennstoffzelle bestehenden Brennstoffzellenanordnung (1), bei welcher an die Brennstoffzellenanordnung eine Betriebslast (2) geschaltet ist, weiters zumindest ein Leistungsverstärker (5',5") zum Einspeisen von zumindest einem niederfrequenten Signal (sₑ₁(t), sₑ₂(t)) vorgesehen ist, dessen Ausgang an die Brennstoffzellenanordnung angekoppelt ist und mit einer gleichfalls an die Brennstoffzellenanordnung angekoppelten Auswerteeinrichtung (6,10,11) zum Erfassen einer Signalantwort (sₐᵢ(t)) auf das zumindest eine eingespeiste Signal (sₑ₁(t), sₑ₂(t)), wobei die Messanordnung dazu eingerichtet ist, der Brennstoffzellenanordnung (1), genau zwei Einzelsignale (sₑ₁(t), sₑ₂(t)) im Niederfrequenzbereich unterschiedlicher Frequenzen f₁, f₂ zuzuführen und die Auswerteeinrichtung dazu eingerichtet ist, die Signalantwort (sₐᵢ(t)) bei ausgewählten Frequenzen f₃, f₄ der Intermodulationsprodukte mf₁ +/- nf₂ der zugeführten Einzelsignale (sₑ₁(t), sₑ₂(t)) zu erfassen-um die gemessenen Intermodulationssignale (sᵢ₁, sᵢ₂) zur Beurteilung des Betriebszustandes heran zu ziehen -, und hinsichtlich zumindest ihrer Amplitude zu messen, um zumindest ein Ausgangssignal (s'_{AZ}, s"_{AZ}) zu erhalten, und die Signalantwort (sₐᵢ(t)) bei Frequenzen der Intermodulationsprodukte 2. Ordnung zu messen, wobei die Messanordnung ferner dazu eingerichtet ist, die Signalantwort (sₐᵢ(t)) bei der Frequenz f₂ - f₁ des niederfrequenten realen Intermodulationsproduktes 2. Ordnung mit Hilfe eines Bandpassfilters (10,11) zu filtern und zu messen sowie auszuwerten.

4. Messanordnung nach Anspruch 3, **dadurch gekennzeichnet, dass** für jedes einzuspeisende Einzelsignal (sₑ₁(t), sₑ₂(t)) ein Leistungsverstärker (5', 5") vorgesehen ist.

5. Messanordnung nach einem der Ansprüche 3 oder 4, **dadurch gekennzeichnet, dass** der Ausgang des zumindest einen Leistungsverstärkers (5',5") über einen Koppelkondensator (C'_{KE}, C"_{KE}) mit der Brennstoffzellenanordnung (1) verbunden ist.

## Claims

1. A method for monitoring the operating state of fuel cells, in which a fuel cell arrangement (1) comprising at least one fuel cell is provided with a signal (sₑ₁(t), sₑ₂(t)) in the low-frequency range and the occurring signal response (sₐᵢ(t)) is measured and evaluated,
wherein the provided signal comprises exactly two individual signals (sₑ₁(t), sₑ₂(t)) of different frequencies f₁, f₂, the signal response (sₐᵢ(t)) is measured at selected frequencies f₃, f₄ of the intermodulation products mf₁ + / - nf₂ of the provided individual signals and the measured intermodulation signals (sᵢ₁, sᵢ₂) are used to assess the operating state, and the signal response (sₐᵢ(t)) is measured at frequencies of the intermodulation products of second-order,
wherein the signal response (sₐᵢ(t)) at the frequency f₂-f₁ of the low frequency real intermodulation product of second order is measured and filtered with the aid of a bandpass filter (10, 11).

2. The method according to claim 1, wherein successive measurements with different amplitudes of the provided individual signals (sₑ₁(t), sₑ₂(t)) are performed and by evaluation of the measured intermodulation signals (sᵢ₁, sᵢ₂) the extent of the nonlinearity of the
current/voltage characteristic curve of the fuel cell arrangement is determined.

3. A measuring arrangement for monitoring the operating state of a fuel cell arrangement comprising at least one fuel cell, in which an operating load is connected to the fuel cell arrangement, furthermore at least one power amplifier (5', 5") for feeding at least one low-frequency signal (sₑ₁(t), sₑ₂(t)) is provided, whose output is coupled to the fuel cell arrangement and with an evaluation device (6, 10, 11) likewise coupled to the fuel cell arrangement for detecting a signal response (sₐᵢ(t)) to the at least one fed signal (sₑ₁(t), sₑ₂(t)),
wherein the measuring arrangement is configured to provide exactly two individual signals (sₑ₁(t), sₑ₂(t)) in the low-frequency range of different frequencies f₁, f₂ to the fuel cell arrangement, and
the evaluation device is configured to detect the signal response (sₐᵢ(t)) at selected frequencies f₃, f₄ of the intermodulation products mf₁ +/- nf₂ of the provided individual signals (sₑ₁(t), sₑ₂(t)) for assessing the operating state and for measuring it according to at least its amplitude to obtain at least one output signal (s'_{AZ}, s"_{AZ}), and further to measure the signal response (sₐᵢ(t)) at frequencies of the intermodulation products of second-order,
wherein the measuring arrangement is further configured to filter and to measure and to evaluate the signal response (sₐᵢ(t)) at the frequency f₂-f₁ of the low frequency real intermodulation product of second order with the aid of a bandpass filter (10, 11).

4. The measuring arrangement according to claim 3, wherein a power amplifier (5',5") is provided for each individual signal (sₑ₁(t), sₑ₂(t)) to be fed.

5. The measuring arrangement according to claim 3 or 4, wherein the output of the at least one power amplifier (5', 5") is connected to the fuel cell arrangement (1) via a coupling capacitor (C'_{KE}, C"_{KE}).

## Revendications

1. Procédé destiné à la surveillance de l'état de fonctionnement de piles à combustible, dans lequel un signal (Sₑ₁(t)), (Sₑ₂(t)) dans la plage de basse fréquence est amené à un agencement (1) de piles à combustible consistant en au moins une pile à combustible, et dans lequel la réponse de signal (Sₐᵢ(t)) se produisant est mesurée et évaluée,
le signal amené comprenant exactement deux signaux individuels (Sₑ₁(t)), (Sₑ₂(t)) de fréquences f₁, f₂ différentes, la réponse de signal (Sₐᵢ(t)) étant mesurée en cas de fréquences f₃, f₄ sélectionnées des produits d'intermodulation mf₁ + / - nf₂ des signaux individuels amenés, et les signaux d'intermodulation (Sᵢ₁, Sᵢ₂) mesurés étant pris en compte pour l'estimation de l'état de fonctionnement,
et la réponse de signal (Sₐᵢ(t)) étant mesurée avec des fréquences des produits d'intermodulation de 2^{ème} ordre, la réponse de signal (Sₐᵢ(t)), avec la fréquence f₂ - f₁ du produit réel d'intermodulation à basse fréquence de 2^{ème} ordre, étant filtrée à l'aide d'un filtre passe-bande (10, 11) et mesurée.

2. Procédé selon la revendication 1, **caractérisé en ce que** des mesures successives sont réalisées avec différentes amplitudes des signaux individuels (Sₑ₁(t)), (Sₑ₂(t)) amenés, et **en ce que** l'étendue de la non-linéarité de la courbe caractéristique de tension électrique de l'agencement de piles à combustible est déterminée par évaluation des signaux d'intermodulation (Sᵢ₁, Sᵢ₂) mesurés.

3. Agencement de mesure destiné à la surveillance de l'état de fonctionnement d'un agencement (1) de piles à combustible consistant en au moins une pile à combustible, dans lequel une charge de fonctionnement (2) est connectée à l'agencement de piles à combustible, au moins un amplificateur de puissance (5', 5") destiné à injecter au moins un signal (Sₑ₁(t)), (Sₑ₂(t)) à basse fréquence étant en outre prévu, dont la sortie est couplée à l'agencement de piles à combustible, et comprenant un dispositif d'évaluation (6, 10, 11) également couplé à l'agencement de piles à combustible, destiné à détecter une réponse de signal (Sₐᵢ(t)) à l'au moins un signal fourni (sₑ₁(t), sₑ₂(t)), l'agencement de mesure étant configuré pour amener exactement deux signaux individuels (Sₑ₁(t)), (Sₑ₂(t)) de fréquences f₁, f₂ différentes dans la plage de basse fréquence, et le dispositif d'évaluation étant configuré pour détecter la réponse de signal (Sₐᵢ(t)) en cas de fréquences f₃, f₄ sélectionnées des produits d'intermodulation mf₁ +/- nf₂ des signaux individuels (Sₑ₁(t)), (Sₑ₂(t)) amenés afin de prendre en compte les signaux d'intermodulation (Sᵢ₁, Si₂) mesurés pour l'estimation de l'état de fonctionnement et pour les mesurer au regard d'au moins leur amplitude, afin d'obtenir au moins un signal de sortie (s'_{AZ}, s"_{AZ}) et de mesurer la réponse de signal (Sₐᵢ(t)) avec des fréquences des produits d'intermodulation de 2^{ème} ordre, l'agencement de mesure étant en outre configuré pour filtrer la réponse de signal (Sₐᵢ(t)) avec la fréquence f₂ - f₁ du produit d'intermodulation réel de basse fréquence de 2^{ème} ordre à l'aide d'un filtre passe-bande (10, 11), pour la mesurer et l'évaluer.

4. Agencement de mesure selon la revendication 3, **caractérisé en ce qu'**un amplificateur de puissance (5', 5") est prévu pour chaque signal individuel (Sₑ₁(t)), (Sₑ₂(t)) à injecter.

5. Agencement de mesure selon l'une quelconque des revendications 3 ou 4, **caractérisé en ce que** la sortie de l'au moins un amplificateur de puissance (5', 5") est reliée à l'agencement de piles à combustible (1) par l'intermédiaire d'un condensateur de couplage (C'_{KE}, C"_{KE}).
